Europäisches Patentamt

European Patent Office

Office européen des brevets

(11) Numéro de publication: **0 238 124 B1**

(12) **FASCICULE DE BREVET EUROPEEN**

(45) Date de publication de fascicule du brevet:
27.02.91

(51) Int. Cl.5: **H03H 11/24**

(21) Numéro de dépôt: **87200363.7**

(22) Date de dépôt: **02.03.87**

(54) Atténuateur à haute impédance d'entrée, à calibres multiples pour hautes fréquences, et oscilloscope et sonde active comportant un tel atténuateur.

(30) Priorité: **14.03.86 FR 8603680**

(43) Date de publication de la demande:
**23.09.87 Bulletin 87/39**

(45) Mention de la délivrance du brevet:
**27.02.91 Bulletin 91/09**

(84) Etats contractants désignés:
**DE FR GB NL**

(56) Documents cités:
**FR-A- 2 369 740
GB-A- 1 375 030
GB-A- 2 161 335
US-A- 4 525 688**

**IEEE JOURNAL OF SOLID-STATE CIRCUITS,
vol. SC-14, no. 1, février 1979, pages 74-79,
IEEE, New York, US; G.L. BALDWIN et al.: "An
MOS digitally controlled analog attenuator
for voiceband signals"**

(73) Titulaire: **LABORATOIRES D'ELECTRONIQUE
PHILIPS
3, Avenue Descartes
F-94450 Limeil-Brévannes(FR)FR**

Titulaire: **N.V. Philips' Gloeilampenfabrieken
Groenewoudseweg 1
NL-5621 BA Eindhoven(NL)DE**

(72) Inventeur: **Boutigny, Pierre-Henri
Société Civile S.P.I.D. 209, rue de l'Université
F-75007 Paris(FR)**

(74) Mandataire: **Chaffraix, Jean et al
Société Civile S.P.I.D. 156, Boulevard Haussmann
F-75008 Paris(FR)**

EP 0 238 124 B1

## Description

L'invention concerne un atténuateur à haute impédance d'entrée, à calibres multiples, destiné à atténuer un signal électrique haute fréquence introduit sur une borne d'entrée de l'atténuateur, ce dernier délivrant sur une borne de sortie à basse impédance un signal de sortie correspondant au signal d'entrée atténué.

L'invention concerne également un oscilloscope et une sonde active pour oscilloscope comprenant un tel atténuateur.

un atténuateur de ce type est connu du document US-A-4 525 688 qui décrit un circuit d'entrée pour oscilloscope comprenant un atténuateur ayant une impédance d'entrée élevée opérant en bande de fréquence large. Des instruments tels que des oscilloscopes, qui doivent permettre d'effectuer des mesures quantitatives de grande précision, nécessitent de disposer de circuits d'entrée d'atténuation ayant une impédance d'entrée élevée afin de ne pas constituer une impédance de charge qui affecterait la source à mesurer.

Pour cela le document cité décrit un atténuateur réglable formé des diviseurs résistifs/capacitifs mis en cascade chacun étant constitué d'un premier circuit parallèle $R_a C_a$ à éléments fixes, d'un second circuit parallèle $R_b C_b$ avec la capacité $C_b$ ajustable, de deux capacités $C_c C_d$ ajustables et de deux interrupteurs $S_a$ et $S_b$ .Les trois capacités ajustables $C_b$, $C_c$ et $C_d$ servent à régler les réponses en fréquence et en niveau de l'atténuateur. Les deux interrupteurs $S_a$ et $S_b$ sont commandés pour utiliser ou non la cellule.

Mais cet atténuateur présente plusieurs inconvénients. Les réglages des différentes capacités, qui sont à effectuer pour chaque calibre, sont nombreux, délicats à réaliser et peu stables, compte tenu de la précision, supérieure à $10^{-2}$, nécessitée par les applications envisagées. Ces réglages qui sont réalisés par le constructeur nécessitent des composants onéreux. Les interrupteurs $S_a$ et $S_b$ sont placés dans la partie à haute impédance de l'atténuateur, de sorte que leurs capacités parasites élevées les rendent mal adaptés à cette application. Leurs dimensions ne peuvent en effet être suffisamment réduites et ceci peut conduire à des capacités d'entrée de l'atténuateur pouvant être de 10 à 20pF.

Un but de l'invention est donc de réduire la capacité d'entrée de l'atténuateur en ne disposant pas de système de commutation mécanique dans la partie haute impédance de l'atténuateur.

Un autre but de l'invention est de supprimer les nombreux réglages délicats du constructeur et d'offrir à l'utilisateur un atténuateur plus commode et plus fiable à utiliser.

Pour cela l'invention telle que définie dans le préambule est remarquable en ce que l'atténuateur comprend k amplificateurs à large bande $A_n (1 \preccurlyeq n \preccurlyeq k)$ de très faible capacité d'entrée,
- . des capacités $D_n$ placées entre chaque entrée et chaque sortie de chaque amplificateur,
- . des capacités $C_n$, placées entre chaque entrée de chaque amplificateur et la borne d'entrée de l'atténuateur, la valeur de la capacité $C_n$ étant obtenue en divisant la va-leur de la capacité $C_{n-1}$ par un coefficient sensiblement égal à une valeur p, les rapports $r_n = C_n/D_n$ étant propres à constituer les coefficients d'une gamme d'atténuation,
- . k commutateurs $I_n$ dont toutes les sorties sont reliées à la borne de sortie de l'atténuateur et dont chaque entrée est réunie individuellement à la sortie d'un des amplificateur, les k commutateurs permettant de sélectionner un des rapports de la gamme d'atténuation, l'atténuateur présentant une très faible capacité d'entrée.

Elle est également remarquable en ce que cet atténuateur à haute impédance d'entrée pour hautes fréquences et à faible capacité d'entrée peut être associé à un étage d'en trée à basse impédance pour former un atténuateur à haute et basse impédance d'entrée et à faible capacité d'entrée. Ces atténuateurs peuvent être utilisés dans les étages d'entrée d'un oscilloscope ou dans une sonde active pour oscilloscope.

Selon l'invention l'atténuateur comprend plusieurs amplificateurs $A_n$ à large bande à faible capacité d'entrée. Chaque amplificateur est destiné à couvrir une gamme d'atténuation donnée. Entre l'entrée et la sortie de l'amplificateur $A_n$, on place une capacité $D_n$ de faible valeur, de l'ordre de la capacité d'entrée de l'amplificateur lui-même. Chaque entrée d'amplificateur est reliée à la borne d'entrée de l'atténuateur par une capacité $C_n$. La sortie de chaque amplificateur peut être sélectionnée à l'aide d'un commutateur $I_n$ relié à la borne de sortie de l'atténuateur. Les capacités $D_n$ ont sensiblement la même valeur, par exemple 1pF, et les capacités $C_n$ sont calibrées de façon à constituer une gamme de coefficients correspondant à l'application. Ainsi la valeur de la capacité $C_n$ se déduit de la valeur de la capacité $C_{n-1}$ en le divisant par un coefficient p par exemple égal à 10, $C_n = C_{n-1}/p$.

En sortie de l'amplificateur $A_n$, on obtient un signal de sortie qui est atténué dans le rapport des capacités $C_n/D_n$. Si pour le premier amplificateur $A_1$ on choisit $C_1 = D_1$, le signal de sortie de l'amplificateur $A_1$ sera égal au signal E appliqué sur la borne d'entrée de l'atténuateur mais délivré sous basse impédance. A la sortie de l'amplificateur $A_2$ le signal obtenu sera égal à $E/p$ et à la sortie du n-ième amplificateur $A_n$ le signal obtenu sera $E/p^n$. Tous ces signaux étant sous basse impédance les commutateurs coaxiaux de sélection $I_n$, adaptés aux basses impédances, placés en sortie, n'apportent pas de perturbation aux signaux atténués. Les sorties de tous ces commutateurs $I_n$ sont reliées entre elles et reliées à la borne de sortie de l'atténuateur. Ainsi aucun dispositif de commutation n'est utilisé dans la section haute tension et haute impédance de l'atténuateur pour sélectionner une gamme d'atténuation. Les très faibles capacités $C_n$ utilisées font que la tenue aux surtensions est aisément obtenue.

Les calibres d'atténuation sont déterminés par le rapport des capacités $C_n/D_n$. Il est possible de réaliser l'ensemble de la gamme de calibres en disposant d'autant d'amplificateurs et d'autant de groupes de capacité $C_n/D_n$ qu'il y a de calibres. Mais pour réduire le nombre d'amplificateurs et pour faciliter l'obtention de calibres bien déterminés, il est préférable de ne réaliser que quelques calibres largement espacés et de compléter la gamme à l'aide d'un amplificateur à gain variable placé après la section basse impédance de l'atténuateur. La précision requise pour les calibres d'oscilloscope étant meilleure que $10^{-2}$, il est préférable de laisser au rapport $C_n/D_n$ une précision moins bonne que $10^{-2}$ et de récupérer la précision de la gamme par l'amplificateur à gain variable. La sortie de celui-ci étant sous basse impédance les calibres intermédiaires sont obtenus à l'aide d'un atténuateur basse tension, basse impédance.

Afin que l'atténuateur puisse également opérer sous basse impédance, on place pour cela, entre la borne d'entrée de l'atténuateur et la masse, un commutateur en série avec une résistance de faible valeur. On obtient ainsi un atténuateur à haute et basse impédance pour hautes fréquences.

Pour traiter les signaux basse fréquence et continu, on place en parallèle avec l'atténuateur haute et basse impédance un atténuateur résistif de type classique.

Cet atténuateur, adapté aux hautes fréquences pour opérer sous haute impédance, complété éventuellement pour opérer sous basse impédance ou pour atténuer des signaux basse fréquence ou continu, est disposé dans l'étage d'entrée d'un oscilloscope. Mais afin de le rendre amovible et facile à utiliser par un utilisateur, il est possible de disposer l'atténuateur haute fréquence et haute impédance dans une sonde pour oscilloscope. Les liaisons sous haute impédance sont ainsi les plus courtes possibles, la liaison avec l'oscilloscope se faisant par câble coaxial basse impédance à travers un boîtier de sonde, placé à l'entrée de l'oscillocope, l'atténuation pouvant être commandée à distance.

L'invention sera mieux comprise à l'aide des figures suivantes, données à titre d'exemples non limitatifs, qui représentent :

figure 1 : un schéma électrique de l'atténuateur, à haute impédance d'entrée pour hautes fréquences selon l'invention,

figure 2 : un dessin pour la réalisation des capacités $C_n$ à l'aide d'un dépôt conducteur sur un substrat,

figure 3 : un schéma de l'atténuateur selon la figure 1 suivi d'un amplificateur à gain variable,

figure 4 : un schéma de l'atténuateur selon la figure 1 comportant en outre des moyens d'adaptation basse impédance,

figure 5 : un schéma de l'atténuateur haute et basse impédance pour hautes et basses fréquences pour oscilloscope,

figure 6 : une représentation schématique des variations du gain avec la fréquence pour des signaux de la figure 5.

figure 7 : un schéma électrique d'une sonde pour oscilloscope.

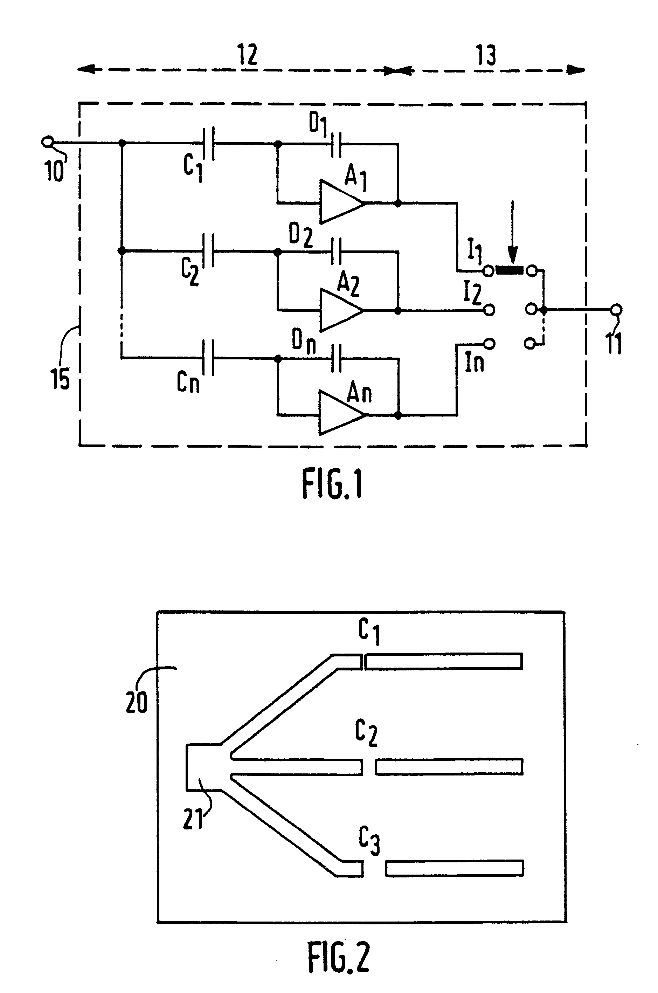

Le schéma électrique de l'atténuateur 15 représenté sur la figure 1 comprend n amplificateurs à large bande $A_1$ à $A_n$, munis respectivement entre leur entrée et leur sortie de capacités $D_1$ à $D_n$. Des capacités $C_1$ à $C_n$ sont disposées entre la borne d'entrée 10 de l'atténuateur 15 et chaque entrée d'amplificateurs. Les sorties des amplificateurs sont reliées individuellement à une première borne de commutateurs $I_1$ à $I_n$ dont toutes les secondes bornes sont reliées à la borne de sortie 11 de l'atténuateur. Préférentiellement les capacités $D_1$ à $D_n$ ont sensiblement la même valeur, par exemple 1pF. La capacité $C_1$ du premier amplificateur est préférentiellement égale à la capacité $D_1$ de sorte que le signal en sortie de l'amplificateur correspond au signal appliqué sur la borne 10, mais atténué d'un rapport $p = C_1/D_1$ égal à 1, mais délivré sous une basse impédance.

Les valeurs des capacités $C_2$ à $C_n$ sont déterminées de façon à obtenir la gamme d'atténuation souhaitée, correspondant aux rapports $C_n/D_n$.

Les signaux en sortie des amplificateurs peuvent être sélectionnés à l'aide des commutateurs $I_1$ à $I_n$.

Les amplificateurs $A_1$ à $A_n$ présentent une impédance d'entrée élevée et une faible capacité d'entrée de sorte que l'atténuateur présente une impédance élevée pour le signal appliqué sur la borne 10. Par contre, à cause du montage capacitif opéré sur chaque amplificateur, ceux-ci présentent une basse impédance de sortie, ce qui permet d'utiliser des commutateurs $I_n$ coaxiaux à basse impédance par exemple 50 ohms. La zone 12 est la zone à haute impédance et haute tension, et la zone 13 est la zone à basse impédance et

3

basse tension.

Dans l'exemple choisi, pour réaliser les trois gammes d'atténuation 1/1, 1/10, 1/100 par exemple, il est nécessaire de donner aux capacités $C_1$, $C_2$, $C_3$ les valeurs respectives 1pF; 0,1pF; 0,01pF; avec $D_1 = D_2 = D_3 = 1pF$.

Les capacités, en particulier $C_1$, $C_2$, $C_3$ doivent présenter de très faibles valeurs. Celles-ci sont obtenues en réalisant les capacités par exemple selon le dessin de la figure 2.

Sur un support 20, on réalise des dépôts conducteurs coplanaires par exemple sous forme longiligne. Chaque dépôt présente une discontinuité de sorte que les deux extrémités placées en vis-à-vis constituent une capacité. La largeur de la discontinuité et la section des conducteurs interrompus déterminent la valeur des capacités. Dans l'exemple choisi, on réalise de cette manière les capacités $C_1 = 1pF$, $C_2 = 0,1pF$ et $C_3 = 0,01pF$. Elles présentent toutes un point commun 21 destiné à être relié à la borne d'entrée de l'atténuateur. L'autre point de chaque capacité va à l'entrée de leur amplificateur respectif.

Il est possible de réaliser les capacités par toute autre méthode, mais dans la plupart des cas il n'est pas nécessaire de s'astreindre à obtenir des valeurs de capacités ayant la tolérance de $10^{-2}$ habituelle nécessaire pour réaliser une gamme d'atténuation correcte pour oscilloscope.

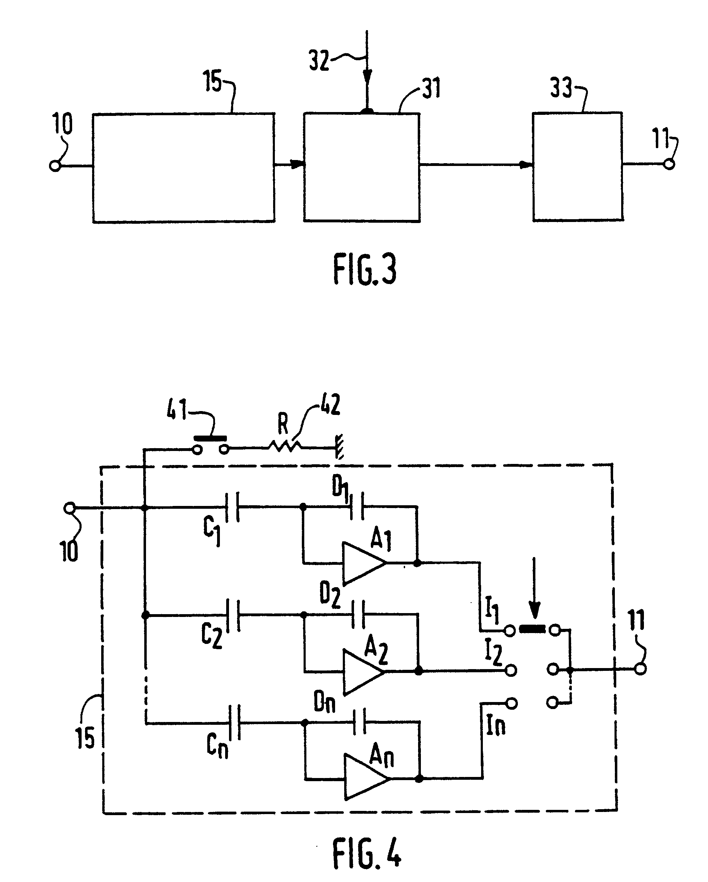

Préférentiellement, l'invention utilise des valeurs de capacité approchées et rétablit la précision requise à l'aide d'un amplificateur à gain variable 31 tel que cela est représenté sur la figure 3. L'atténuateur actif 15 précédent fournit des calibres voisins de par exemple 1, 1/10, 1/100. Sa sortie pénètre dans l'amplificateur à gain variable 31 qui possède une entrée 32 sur laquelle est introduit un signal de contrôle destiné à programmer les gains de l'amplificateur 31 de sorte que l'atténuation totale corresponde exactement aux valeurs désirées. Cet amplificateur intervient après la zone à basse impédance de l'atténuateur 15 ce qui permet d'obtenir correctement les calibres pour toute la gamme hautes fréquences considérée.

A l'aide d'un atténuateur basse tension et basse impédance 33 placé après l'amplificateur 31 les rapports d'atténuation intermédiaires, par exemple 1/1, 1/2, 1/5 sont obtenus pour couvrir les gammes habituellement utilisées en oscilloscopie. Le signal de contrôle appliqué sur l'entrée 32 permet non seulement au constructeur mais également à l'utilisateur d'opérer les réglages. Le réglage d'un tel atténuateur nécessite simplement 3 ajustements de tension continue nécessaires à la commande de l'amplificateur à gain variable dans les trois positions 1/1, 1/10, 1/100.

Ceci est sans nul doute beaucoup plus simple et fiable que les solutions antérieures qui n'étaient pratiquement réalisables que par le constructeur.

L'atténuateur représenté sur la figure 3 présente une haute impédance d'entrée aux hautes fréquences. Mais il est généralement utile de disposer aux hautes fréquences d'un atténuateur ayant une basse impédance d'entrée et une faible capacité d'entrée.

Pour cela le schéma électrique de la figure 4 représente un atténuateur permettant à l'utilisateur de choisir entre une haute et une basse impédance d'entrée. Il est constitué de l'atténuateur à haute impédance d'entrée 15 sur la borne d'entrée duquel est connecté un commutateur 41 à basse impédance, par exemple coaxial, et une résistace R42 de faible valeur réunie à la masse. Cette résistance a par exemple une valeur de 50 ohms comme il est d'usage en oscilloscopie.

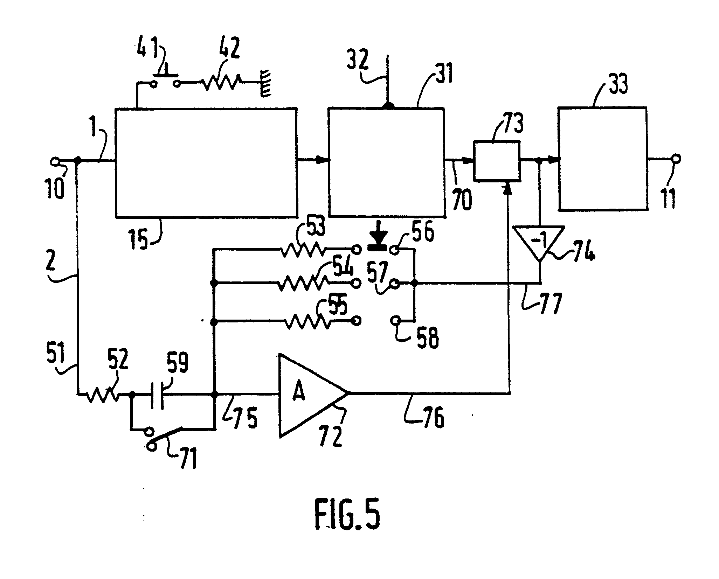

Afin de pouvoir opérer sur des signaux à hautes fréquences d'une part, et sur des signaux à basses fréquences ou de signaux continus d'autre part, on utilise l'atténuateur représenté sur la figure 5.

Les signaux basses fréquences et continus sont orientés sur une branche 51 qui comprend un pont diviseur résistif constitué d'une résistance de tête 52 et de résistances de pont par exemple 53, 54, 55 pour trois calibres. Avec des résistances 52, 53, 54, 55 ayant respectivement pour valeur 1 Megohm, 1 Megohm, 100 Kohms et 10 Kohms, la situation représentée sur la figure 5 correspond aux trois mêmes calibres que précédemment soit 1/1, 1/10, et 1/100. Ils peuvent être sélectionnés par des commutateurs 56, 57, 58. La précision des résistances est suffisante pour éviter tout ajustement. En basse fréquence le signal appliqué passe à travers une capacité 59 qui peut être court-circuitée par un commutateur 71 pour opérer avec des signaux continus, afin de réaliser les deux modes de couplage nécessaires "alternatif" et "continu".

La capacité est placée entre la résistance de tête 52 et un point commun aux résistances de pont 53, 54, 55, lui-même relié à l'entrée d'un amplificateur opérationnel 72. Celui-ci délivre un signal qui est traité par un circuit d'addition 73 pour former un signal conforme au signal d'entrée mais atténué selon les calibres choisis. Les commutateurs 56, 57 et 58 et les commutateurs $I_n$ de l'atténuateur 15 opèrent en synchronisme. La sortie du circuit d'addition 73 entre dans un amplificateur à gain négatif 74 dont la sortie est reliée au point commun aux commutateurs 56, 57, 58. La boucle ainsi constituée par la mise en série de l'amplificateur 72, du circuit d'addition 73, de l'amplificateur à gain négatif 74, d'un des commutateurs 56, 57, 58 associé respectivement à une des résistances 53, 54, 55, permet de régler l'atténuation de la partie à basse fréquence sur celle de la partie à haute fréquence. La sortie du circuit d'addition entre dans l'atténuateur basse tension et basse impédance 33 qui détermine les calibres intermédiaires.

Le fonctionnement du circuit de la figure 5 s'analyse de la façon suivante. Soit Ve le signal présent sur la borne 10 et soit Vs celui sur la connexion 70 dû à la voie 1. L'atténuateur fixe 15 et l'atténuateur variable 31 constituent un atténuateur à haute fréquence. La tension de sortie Vs d'un tel atténuateur s'écrit :

$$Vs = -K \frac{s \, \tau_H}{1+s . \tau_H} \; Ve$$

avec K : rapport d'atténuation 1, 1/10, 1/100

$\tau_H$ : tel que l'inverse de $\tau_H$ est égal à la fréquence de coupure basse de l'atténuateur HF.

s : élément de calcul symbolique.

D'autre part, l'amplificateur opérationnel 72 présente un gain G et une fréquence de coupure haute. En appelant :

"*"$_\epsilon$ le signal sur la connextion 75 à l'entrée de l'amplificateur 72,

"*"X le signal sur la connexion 76 en sortie de l'amplificateur 72

"*"$G_H$ le gain de la voie haute fréquence 1,

on peut écrire les relations suivantes :

(1) $Vs = - G_H . Ve$

$$(2) \quad \epsilon = \frac{K}{1+K} \, Ve - \frac{S}{1+K}$$

(3) $X = - G_B . \epsilon$

(4) $S = - Vs - X.$

Ces relations permettent d'obtenir la relation suivante :

$$(5) \qquad \frac{S}{Ve} = \frac{G_H + \frac{K}{1+K} \cdot G_B}{1 + \frac{G_B}{1+K}}$$

Or le gain $G_H$ de la voie HF 1 est :

$G_H = K.g_H$, où $g_H$ est le gain d'un des amplificateurs A1 à An, avec $g_h = 1$ quand la fréquence devient très élevée.

La relation (5) s'écrit :

$$(6) \qquad \frac{S}{Ve} = K \left( 1 + \frac{g_H - 1}{1 + \frac{1}{1+K} G_B} \right)$$

L'atténuation globale de l'étage comprend donc un terme k correspondant à l'atténuation large bande, additionné au terme parasite :

$$(7) \qquad K . \frac{g_H - 1}{1 + \frac{1}{1+K} . G_B}$$

Ce terme doit donc être minimisé sur toute la bande de fréquences pour obtenir un gain constant égal à K.

En termes de réponse en fréquences on peut écrire:

$$g_H = \frac{s \cdot \tau_H}{1+s\tau_B}$$

pour l'atténuateur HF et

$$G_B = \frac{g_o}{1+s\tau_B}$$

pour l'amplificateur opérationnel $A_n$ où $g_o > 1$.

Le numérateur du terme parasite (7) s'écrit :

$$g_H - 1 = \frac{-1}{1+s\tau_H}$$

et le dénominateur :

$$1 + \frac{1}{1+K} G_B = \frac{(1+K)(1+s\tau_B) + G_o}{(1+K)(1+s\tau_B)}$$

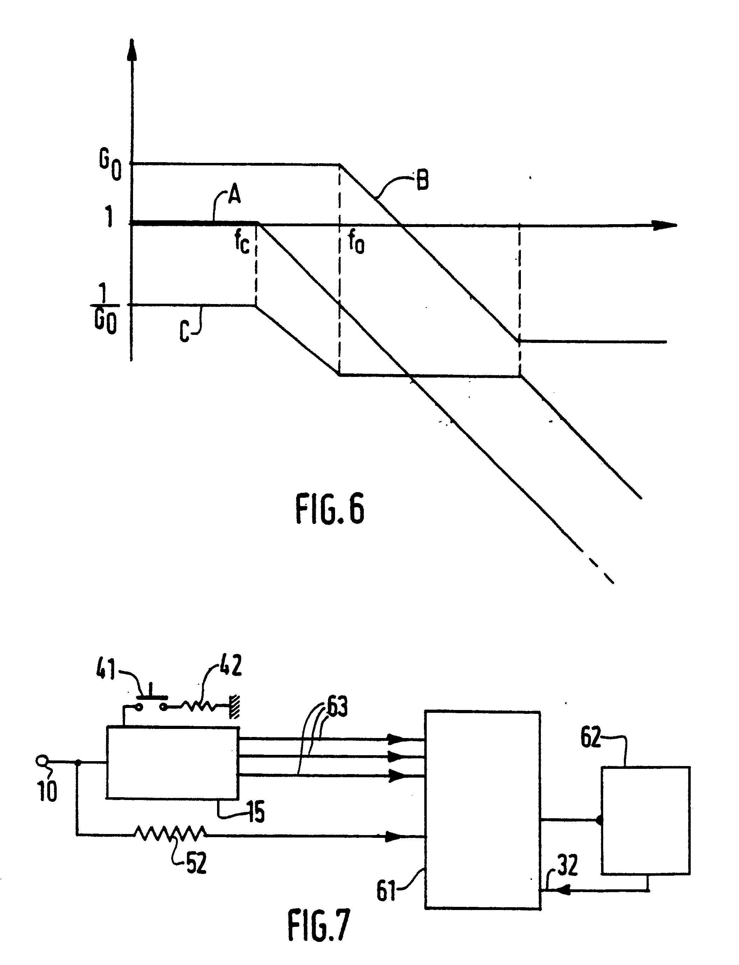

La courbe A de la figure 6 représente l'évolution du gain relatif au numérateur avec une fréquence de coupure

$$f_c = \frac{1}{2\pi\tau_H}$$

à partir de laquelle le gain décroît continûment.

De même la courbe B représente l'évolution du gain relatif au dénominateur avec une fréquence de coupure basse

$$f_o = \frac{1}{2\pi(1+K)\tau_B}$$

et une fréquence de coupure haute de $(1 + K + G_o)f_o$.

Les variations du terme parasite représenté par l'équation (7) sont représentées sur la courbe C. Ce terme doit rester le plus faible possible et ne pas présenter un accroissement sur toute la bande de fréquences. Pour cela il est nécessaire que la fréquence de coupure $f_c$ soit inférieure à la fréquence de coupure $f_o$. Si ceci n'était pas respecté la courbe C présenterait une pente positive sur la figure 6 entre $f_c$ et $f_o$ suivie d'un palier ce qui ne permetterait pas d'avoir une atténuation constante égale à K sur toute la bande. Il faut également que la fréquence haute $(1 + K + G_o)f_o$ soit très supérieure à $f_c$. Ceci signifie que le produit gain bande $G_o.f_o$ de l'amplificateur opérationnel 72 soit très supérieur à la fréquence de coupure basse de l'amplificateur haute fréquence de la voie 1.

Ainsi à titre d'exemple avec un amplificateur HF ayant une bande passante de 1 KHz à 2 GHz il faut que le produit gain-bande de l'amplificateur opérationnel soit de l'ordre de 100 KHz.

Un tel atténuateur opérant à haute et/ou à basse impédance d'entrée pour des signaux à hautes et/ou à basses fréquences selon les schémas électriques des figures 1, 3, 4 ou 5 peut être utilisé dans les étages d'entrée d'appareillages électriques, particulièrement des appareillages de mesure tels que les oscilloscopes. Dans ce dernier cas, il est généralement souhaitable de disposer d'un dispositif amovible sous la forme d'une sonde active pour oscilloscope. La séparation qui existe, dans l'atténuateur selon l'invention, entre une zone à haute tension et haute impédance et une zone à basse tension et basse impédance permet de disposer d'une sonde active pour laquelle les liaisons hautes fréquences avec l'oscilloscope sont réalisées sous basse impédance. Le schéma électrique d'une telle sonde est représenté sur la figure 7. Le signal électrique pénêtre par la borne d'entrée 10 dans l'atténuateur 15 à haute impédance d'entrée pour hautes fréquences. Il peut être muni du commutateur 41 et de la résistance de faible valeur 42 pour opérer sous basse impédance. Mais cette dernière disposition n'est pas indispensable. Les signaux sélectionnés par les commutateurs $I_n$ sont transférés à l'aide de câbles coaxiaux 63, par exemple 50 ohms, vers un boîtier de sonde 61 qui peut être fixé sur la fiche d'entrée d'un oscilloscope 62. Il y a une liaison coaxiale par calibre. Les signaux basses fréquences sont transférés séparément à l'aide d'une liaison basse fréquence à travers la résistance 52. Les rapports d'atténuation peuvent être contrôlés à distance à partir du tableau de commande de l'oscilloscope qui envoie des signaux de contrôle sur l'entrée 32 de l'amplificateur à gain variable. L'atténuateur à haute impédance 15 peut ainsi être disposé dans l'embout de la sonde active et constituer une sonde de très petites dimensions, les éléments de commutation à basse impédance étant ramenés dans un boîtier de sonde contigu à l'oscilloscope.

**Revendications**

1. Atténuateur à haute impédance d'entrée, à calibres multiples, destiné à atténuer un signal électrique haute fréquence introduit sur une borne d'entrée (10) de l'atténuateur, ce dernier délivrant sur une borne de sortie à basse impédance (11) un signal de sortie correspondant au signal d'entrée atténué, caractérisé en ce que l'atténuateur comprend k amplificateurs à large bande $A_n$(1 n k) de très faible capacité d'entrée,
   - des capacités $D_n$ placées entre chaque entrée et chaque sortie de chaque amplificateur,
   - des capacités $C_n$, placées entre chaque entrée de chaque amplificateur et la borne d'entrée (10) de l'atténuateur, la valeur de la capacité $C_n$ étant obtenue en divisant la valeur de la capacité $C_{n-1}$ par un coefficient sensiblement égal à une valeur p, les rapports $r_n = C_n/D_n$ étant propres à constituer les coefficients d'une gamme d'atténuation,
   - k commutateurs $I_n$ dont toutes les sorties sont reliées à la borne de sortie (11) de l'atténuateur et dont chaque entrée est réunie individuellement à la sortie d'un des amplificateur, les k commutateurs permettant de sélectionner un des rapport de la gamme d'atténuation, l'atténuateur présentant une très faible capacité d'entrée.

2. Atténuateur selon la revendication 1, caractérisé en ce que les capacités $D_n$ ont sensiblement la même valeur $C_o$.

3. Atténuateur selon la revendication 2, caractérisé en ce que la capacité $C_1$ est sensiblement égale à $C_o$ et en ce que la valeur p est sensiblement égale à 10.

4. Atténuateur selon une des revendications 1 à 3, caractérisé en ce que chaque capacité $C_n$ est constituée par deux conducteurs dont la proximité l'un par rapport à l'autre détermine la valeur de chaque capacité $C_n$.

5. Atténuateur selon la revendication 4, caractérisé en ce que chaque capacité $C_n$ est constituée de deux conducteurs coplanaires formés à partir d'une bande conductrice déposée sur un substrat qui est interrompue sur une distance déterminant la valeur de la capacité $C_n$.

6. Atténuateur selon une des revendications 1 à 5, caractérisé en ce qu'il comprend en outre un amplificateur (31) à large bande à gain variable, contrôlable extérieurement, connecté à la borne commune des k commutateurs $I_n$.

7. Atténuateur opérant à haute ou basse impédance d'entrée caractérisé en ce qu'il comprend un atténuateur à haute impédance d'entrée selon une des revendications 1 à 6 et en outre un autre commutateur (41) en série avec la borne d'entrée (10) de l'alténuateur et avec une résistance R de faible valeur réunie à la masse.

8. Atténuateur selon la revendication 7, caractérisé en ce que la résistance R est égale à 50 ohms.

9. Oscilloscope caractérisé en ce qu'il comprend un atténuateur selon une des revendications 1 à 8.

EP 0 238 124 B1

**10.** Sonde active pour oscilloscope caractérisée en ce qu'elle comprend un atténuateur selon une des revendications 1 à 8.

**11.** Sonde active selon la revendication 10, caractérisée en ce que l'atténuateur à haute impédance d'entrée pour hautes fréquences est placé dans un embout relié par des liaisons à basse impédance à un boîtier de sonde connectable à l'oscilloscope.

**Claims**

1. An attenuator having a high input impedance and several switching levels intended to attenuate a high-frequency electric signal introduced at an input terminal (10) of the attenuator, the latter supplying at a low-impedance output terminal (11) an output signal corresponding to the attenuated input signal, characterized in that the attenuator comprises $k$ broadband amplifiers $A_n$ ($1 \leq n \leq k$) having a very small input capacitance,
   - capacitances $D_n$ arranged between each input and output of each amplifier.
   - capacitances $C_n$ arranged between each input of each amplifier and the input terminal (10) of the attenuator, the value of the capacitance $C_n$ being obtained by dividing the value of the capacitance $C_{n-1}$ by a coefficient substantially equal to a value $p$, the ratios $r_n = C_n/D_n$ being suitable to form the coefficients of an attenuation range,
   - $k$ switches $I_n$, of which all the outputs are connected to the output terminal (11) of the attenuator, and each input of which is individually connected to the output of one of the amplifiers, the $k$ switches permitting of choosing one of the ratios of the attenuation range, the attenuator having a very small input capacitance.

2. An attenuator as claimed in Claim 1, characterized in that the capacitances $D_n$ all have substantially the same value $C_0$.

3. An attenuator as claimed in Claim 2, characterized in that the capacitance $C_1$ is substantially equal to $C_0$ and in that the value $p$ is substantially equal to 10.

4. An attenuator as claimed in any one of Claims 1 to 3, characterized in that each capacitance $C_n$ is constituted by two conductors, whose relative proximity determines the value of each capacitance $C_n$.

5. An attenuator as claimed in Claim 4, characterized in that each capacitance $C_n$ is constituted by two coplanar conductors formed from a conducting strip deposited on a substrate, which strip is interrupted over a distance determining the value of the capacitance $C_n$.

6. An attenuator as claimed in any one of Claims 1 to 5, characterized in that it further comprises a broadband amplifier (31) having a variable amplification that can be externally controlled and is connected to the common terminal of $k$ switches $I_n$.

7. An attenuator operating at a high or low input impedance, characterized in that it comprises an attenuator having a high input impedance as claimed in any one of Claims 1 to 6 and further another switch (41) in series with the input terminal (10) of the attenuator and with a resistor R of low value connected to earth.

8. An attenuator as claimed in Claim 7, characterized in that the resistor R has a value of 50 ohms.

9. An oscilloscope, characterized in that it comprises an attenuator as claimed in any one of Claims 1 to 8.

10. An active probe for an oscilloscope, characterized in that it comprises an attenuator as claimed in any one of Claims 1 to 8.

11. An active probe as claimed in Claim 10, characterized in that the attenuator having a high input impedance for high frequencies is arranged in a nipple connected by low-impedance connections to a probe box that can be connected to the oscilloscope.

8

# EP 0 238 124 B1

## Ansprüche

1. Dämpfungsglied mit hoher Eingangsimpedanz und Mehrfachmeßbereichen zum Dämpfen eines elektrischen Hf-Signals, das an eine Eingangsklemme (10) des Dämpfungsglieds gelangt, das eine Niederimpedanz-Ausgangsklemme (11) mit einem dem gedämpften Eingangssignal entsprechenden Ausgangssignal beliefert, dadurch gekennzeichnet, daß das Dämpfungsglied k Breitbandverstärker $A_n$ (1 < n < k) mit sehr schwachem Eingangskapazität,
   - . zwischen jedem Eingang und jedem Ausgang jedes Verstärkers angeordnete Kapazitäten $D_n$
   - . zwischen jedem Eingang jedes Verstärkers und der Eingangsklemme (10) des Dämpfungsglieds angeordnete Kapazitäten $C_n$, wobei der Wert der Kapazität $C_n$ durch Teilung des Wertes der Kapazität $C_{n-1}$ durch einen im wesentlichen dem Wert p gleichen Koeffizienten erhalten wird, wobei sich die Verhältnisse $r_n = C_n/D_n$ zum Darstellen der Koeffizienten eines Dämpfungsbereichs eignen, und
   - . k Schalter $I_n$ enthält, von denen alle Ausgänge mit der Ausgangsklemme (11) des Dämpfungsglieds und von denen jeder Eingang einzeln mit dem Ausgang eines der Verstärker verbunden sind, wobei die k Schalter zum Wählen eines der Verhältnisse des Dämpfungsbereichs dienen, weil das Dämpfungsglied eine sehr schwache Eingangskapazität besitzt.

2. Dämpfungsglied nach Anspruch 1, dadurch gekennzeichnet, daß die Kapazitäten $D_n$ im wesentlichen alle denselben Wert $C_o$ besitzen.

3. Dämpfungsglied nach Anspruch 2, dadurch gekennzeichnet, daß jede Kapazität $C_1$ im wesentlichen gleich Co ist, und daß der Wert p im wesentlichen gleich 10 ist.

4. Dämpfungsglied nach Anspruch 1 bis 3, dadurch gekennzeichnet, daß jede Kapazität $C_n$ aus zwei Leitern besteht, deren gegenseitiger Abstand den Wert jeder Kapazität $C_n$ bestimmt.

5. Dämpfungsglied nach Anspruch 4, dadurch gekennzeichnet, daß jede Kapazität $C_n$ aus zwei koplanaren Leitern besteht, die aus einem auf einem Substrat angebrachten Leitstreifen gebildet wird, der in einem den Wert der Kapazität $C_n$ bestimmenden Abstand unterbrochen ist.

6. Dämpfungsglied nach Anspruch 1 bis 5, dadurch qekennzeichnet, daß es außerdem einen Breitbandverstärker (31) mit änderbarem Verstärkungsgrad enthält, der von außen her steuerbar und mit der gemeinsamen Klemme der k Schalter $I_n$ verbunden ist.

7. Dämpfungsglied mit hoher oder niedriger Eingangsimpedanz, dadurch gekennzeichnet, daß es ein Dämpfungsglied mit hoher Eingangsimpedanz nach einem der Ansprüche 1 bis 6 und außerdem einen anderen Schalter (41) enthält, der mit der Eingangsklemme (10) des Dämpfungsglieds und mit einem schwachen, an Masse liegenden Widerstand R in Reihe geschaltet ist.

8. Dämpfungsglied nach Anspruch 7, dadurch gekennzeichnet, daß der Widerstand R gleich 50 Ohm ist.

9. Oszillograph, dadurch gekennzeichnet, daß er ein Dämpfungsglied nach einem der Ansprüche 1 bis 8 enthält.

10. Aktive Probe für einen Oszillographen, dadurch gekennzeichnet, daß sie ein Dämpfungsglied nach einem der Ansprüche 1 bis 8 enthält.

11. Aktive Probe nach Anspruch 10, dadurch gekennzeichnet, daß das Hf-Dämpfungsglied mit hoher Eingangsimpedanz in einem Ansatz angeordnet ist, der durch Niederimpedanzverbindungen mit einem an den Oszillographen anschließbaren Probengehäuse verbunden ist.

9

FIG.1

FIG.2

FIG.3

FIG.4

FIG.5

FIG.6

FIG.7